# EUROPÄISCHE PATENTSCHRIFT

(11) **EP 2 693 494 B1**
(45) Veröffentlichungstag und Bekanntmachung des Hinweises auf die Patenterteilung: **17.06.2020**
(21) Anmeldenummer: 12005553.8
(22) Anmeldetag: 31.07.2012
(51) Int. Cl.: H01L 31/048, H01L 31/052

(54) **Solarzelleneinheit**
Solar cell unit
Unité de cellules solaires

(43) Veröffentlichungstag der Anmeldung: 05.02.2014
(73) Patentinhaber: AZURSPACE Solar Power GmbH, 74072 Heilbronn (DE)
(72) Erfinder: Khorenko, Victor, 74196 Neuenstadt a. K. (DE); Zrinscak, Ivica, 74074 Heilbronn (DE)
(74) Vertreter: Koch Müller Patentanwaltsgesellschaft mbH

(56) Entgegenhaltungen:
- EP-A1- 2 312 646
- WO-A1-2010/137687
- DE-A1-102011 084 054

## Beschreibung

Die Erfindung betrifft eine Solarzelleneinheit.

Aus der EP 2 073 279 A1 ist ein Solarzellenmodul bekannt, bei dem ein als Solarzelle ausgebildeter Halbleiterkörper auf einem Träger angeordnet ist. Um den Halbleiterkörper und insbesondere dessen Seitenflächen vor Umgebungseinflüssen zu schützen, die zu einer Degradation der elektrischen Parameter führen, wird um den Halbleiterkörper an vier Seiten ein Rahmen angeordnet und mit einem transparenten Deckel abgeschlossen. Anschließend wird der verbleibende Zwischenraum mit einer transparenten Vergussmasse aufgefüllt und ein optisches Element angebracht.

Aus der EP 1 953 825 A2 ist eine weitere Solarzelleneinheit bekannt. Hierbei wird auf einem Träger ein als Solarzelle ausgebildeter Halbleiterkörper angeordnet. Anschließend werden zum Schutz des Halbleiterkörpers eine Dichtfolie und ein aus mehreren Teilen bestehendes Gehäuse, welches auch ein optisches Element umfasst, in einem mehrstufigen Prozess auf dem Träger angeordnet.

Aus der DE 10 2009 006 286 A1 ist eine Solarzelleneinheit bekannt, welches eine Vielzahl von einzelnen Solarzellen auf einem Träger aufweist. Unter anderem ist oberhalb der Solarzelle ein optisches Element, welches auch als sekundäres optisches Element bezeichnet "SOE" wird, angeordnet. Das optische Element leitet das durch eine Fresnellinse fokussierte Licht der Sonne auf die Oberfläche der Solarzelle. Mittels der fokussierenden Anordnung lassen sich mit wenigen kleinen Solarzellen, welche einen Wirkungsgrad bis zu 40% und darüber aufweisen, großflächige Solarzelleneinheiten aufbauen. Des Weiteren sind aus EP 2 312 646 A1, der WO 2010 / 137 687 A1 und der DE 10 2011 084054 A1 derartige Vorrichtungen offenbart.

Insbesondere offenbart die EP 2 312 646 A1 eine Solarzelleneinheit, die eine Solarzelle auf einem Träger umfasst. Ein optisches Element führt Licht auf die Vorderseite der Solarzelle. Ein Teil der Unterseite des optischen Elements ist auf der Vorderseite der Solarzelle angeordnet und ist mit der Solarzelle kraftschlüssig verbunden. Eine Polymerklebeschicht überdeckt die Solarzelle und ist zwischen der Solarzelle und der Unterseite des optischen Elements angeordnet.

Vor diesem Hintergrund besteht die Aufgabe der Erfindung darin, eine Vorrichtung anzugeben, die den Stand der Technik weiterbildet.

Die Aufgabe wird durch eine Solarzelleneinheit mit den Merkmalen des Patentanspruchs 1 gelöst. Vorteilhafte Ausgestaltungen der Erfindung sind Gegenstand von Unteransprüchen.

Es sei angemerkt, dass es sich bei der Solarzelle vorzugsweise um eine III-V Halbleitersolarzelle auf GaAs Basis handelt und die Solarzelle höchst vorzugsweise als stapelförmig angeordnete Mehrfachsolarzelle ausgebildet ist und unter anderem mittels Nutzung von UV-Lichtanteilen Wirkungsgrade oberhalb 30% aufweist. Derartige Solarzelleneinheiten werden, unter anderem wegen den im Vergleich zu den Siliziumsolarzellen höheren Herstellkosten, bevorzugt in sogenannten CPV-Systemen eingesetzt. In den CPV-Systemen wird das Sonnenlicht um Faktoren oberhalb von 50 gebündelt. Hierbei wird das mittels eines primären optischen Konzentrators bzw. Elements gebündelte Licht auf ein sekundäres optisches Element geleitet. Das Primäre Element ist oberhalb des sekundären optischen Elements angeordnet. Von dem sekundären optischen Element wird das Licht durch die Polymerkleberschicht hindurch auf die Vorderseite der Solarzelle geleitet.

Um die optischen Verluste gering zu halten, muss die Polymerkleberschicht neben einer hohen UV-Beständigkeit auch in dem gesamten auszunutzenden Spektralbereich besonders transparent ausgebildet sein. Außerdem werden durch die hohe Konzentration des Sonnenlichtes hohe Temperaturen bis zu 120°C auf der Vorderseite der Solarzelle erzielt, d. h. die Polymerkleberschicht muss besonders temperatur- und alterungsbeständig ausgeführt sein.

Ein Vorteil der erfindungsgemäßen Vorrichtung ist es, dass das sekundäre optische Element eine weitestgehend plane Oberfläche aufweist und sich hierdurch einfach und kostengünstig herstellen lässt. Indem zwischen der Unterseite des sekundären optischen Elements und der Oberseite des Trägers bzw. der Vorderseite der Solarzelle eine Polymerkleberschicht, die vorzugsweise eine Kunststoffverbindung und höchst vorzugsweise eine Silikonverbindung umfasst, ausgebildet ist, lässt sich ohne weitere Verbindungsmittel eine kraftschlüssige Verbindung auf einfache und kostengünstige Weise herstellen. Es versteht sich, dass zwischen Vorderseite der Solarzelle und der Unterseite des sekundären optischen Elements die Polymerkleberschicht eine geringe Dicke, vorzugsweise unterhalb 2 mm, höchst vorzugsweise unterhalb 0,5 mm ausgebildet ist.

Es zeigt sich, dass die Polymerkleberschicht dichtende Eigenschaften aufweist und die Oberseite des Trägers sowie den Halbleiterkörper und Insbesondere die Seitenflächen des Halbleiterkörpers durch die Polymerkleberschicht zuverlässig vor Umgebungseinflüssen geschützt sind. Weitere Untersuchungen haben gezeigt, dass eine zusätzliche Abdichtungsschicht, die Insbesondere den äußeren Rand der kissenförmig ausgebildeten Polymerkleberschicht umschließt, sich erübrigt. Hierdurch lässt sich die Anzahl der Fertigungsschritte zur Herstellung der Solarzellenelnheit weiter reduzieren. Ein Vorteil der klssenförmigen Ausbildung der Polymerkleberschicht unterhalb der weitestgehend planen Oberfläche ist, dass eine Begrenzung für eine laterale Ausdehnung der Polymerkleberschicht fehlt. Eine Ausdehnung oder ein Schrumpfen der Polymerkleberschicht sowohl senkrecht zu der Richtung der Oberseite des Trägers als auch senkrecht zu der Richtung Infolge einer Temperaturänderung und / oder Feuchtigkeitsänderung ist hierdurch ohne weiters möglich. Hierdurch lässt sich die Wahrscheinlichkeit einer Delamination zwischen der Polymerkleberschicht und dem Träger reduzieren. Untersuchungen haben gezeigt, dass bereits eine Ausbildung der Polymerkleberschicht in dem Zentralbereich an der Unterseite des optischen Elements und in einem Zentralen Bereich auf der Oberseite des Trägers bzw. mit der Vorderseite des Halbleiterkörpers eine kraftschlüssige Verbindung herstellt.

In einer Ausführungsform ist die Polymerkleberschicht als Vergussmasse zwischen der gesamten Unterseite des sekundären optischen Elements und an der Oberseite des Trägers ausgebildet, wobei die Vorderseite des Halbleiterkörpers und die Seitenflächen des Halbleiterkörpers formschlüssig überdeckt sind. Gemäß einer alternativen Ausführungsform schließt die Polymerkleberschicht seitlich bündig mit dem Rand an der Unterselte des sekundären optischen Elements ab.

Gemäß einer bevorzugten Ausführungsform ist auf der Oberseite des Trägers d. h. In dem Raum zwischen Unterseite des sekundären optischen Elements und der Oberseite des Trägers eine Schutzdiode, vorzugsweise ausgebildet als Bypassdiode, angeordnet und weist eine elektrische Verbindung mit dem ersten Leiterbahnbereich und dem zweiten Leiterbahnbereich auf. Die Schutzdiode ist kraftschlüssig mit der Oberseite des Trägers verbunden und mit dem ersten Leiterbahnbereich und dem zweiten Leiterbahnbereich verschaltet. Es sei angemerkt, dass die Solarzelle auch eine Diodencharakteristik aufweist und die Schutzdiode antiparallel zu der Solarzelle geschaltet ist. Die aus der Oberseite des Trägers hervorstehenden Flächen der Schutzdiode sind vorzugsweise von der Polymerkleberschicht bedeckt.

Bei einer anderen Ausführungsform ist ein erster mit dem ersten Leiterbahnbereich elektrisch verschalteter Kontaktstreifen ausgebildet, wobei der erste Kontaktstreifen seitlich über die Oberseite in einem Randbereich des Trägers hinausragt. Ferner ist ein zweiter mit dem zweiten Leiterbahnbereich elektrisch verschalteter Kontaktstreifen ausgebildet, wobei der zweite Kontaktstreifen seitlich über die Oberseite In dem Randbereich des Trägers hinausragt.

Bevorzugt Ist es, die Fläche an der Oberseite des Trägers gleich groß wie die Fläche an der Unterseite des optischen Elements auszubilden. Hierdurch lassen sich mehrere Solarzelleneinheiten bündig aneinanderreihen. Vorzugsweise ist der Träger plattenförmig ausgebildet und umfasst höchst vorzugsweise eine Keramikverbindung.

Bei einer anderen Weiterbildung ist an der Unterseite des Trägers eine Metallschicht als Teil des Trägers ausgebildet, wobei die Metallschicht vorzugsweise in einem umlaufenden Randbereich unmittelbar am Rand des Trägers nicht ausgebildet ist. Ein Vorteil der Metallschicht Ist, dass gegenüber einem Träger ohne rückseitige Metallschicht, die Wärme von der Oberseite des Trägers gleichmäßiger auf den gesamten Träger übertragen wird. Untersuchungen haben gezeigt, dass durch die gleichmäßigere Verteilung der Wärme auch eine höhere Abstrahlung von der Rückseite erfolgt. Ferner lässt sich bei einer Montage des Trägers auf einer Unterlage mittels der rückseitigen Metallschicht der Wärmeübergangswiderstand zwischen der Unterlage und dem In einer Weiterbildung Ist zwischen der Oberfläche der Ausformung und der Polymerkleberschlcht eine erste Haftvermittlerschicht ausgebildet ist. In einer alternativen Ausführungsform ist die erste Haftvermittlerschicht an der gesamten Unterseite des sekundären optischen Elements ausgebildet und mit der Unterseite stoffschlüssig verbunden. Untersuchungen haben gezeigt, dass sich die Haftung zwischen der Polymerkleberschicht und der weitestgehend planen Unterseite des sekundären optischen Elements mit der Ausbildung einer dünnen Haftvermittlerschicht wesentlich erhöhen und hierdurch die Zuverlässigkeit steigern lässt. In einer anderen Weiterbildung ist zwischen der Polymerkleberschicht und der Vorderseite des Halbleiterkörpers eine zweite Haftvermittlerschicht ausgebildet und die zweite Haftvermittlerschicht mit der Vorderseite des Halbleiterkörpers stoffschlüssig verbunden. Mit der Ausbildung der zweiten Haftvermittlerschicht lässt sich die Zuverlässigkeit weiter erhöhen. Gemäß einer alternativen Ausführungsform ist die zweite Haftvermittlerschicht auch auf der Oberseite des Trägers ausgebildet. Es ist bevorzugt, die erste Haftvermittlerschicht und / oder die zweite Haftvermittlerschicht transparent und sehr dünn auszuführen, vorzugsweise beträgt die Dicke weniger als 0,5 mm, höchst vorzugsweise weniger als 0,05 mm.

Es versteht sich, dass die beiden Haftvermittlerschichten im Vergleich zu der Polymerkleberschicht eine unterschiedliche chemische Zusammensetzung aufweisen.

Gemäß einer bevorzugten Ausführungsform ist auf der Oberseite des Trägers eine Schutzdiode, vorzugsweise ausgebildet als Bypassdiode, angeordnet und mit dem ersten Leiterbahnbereich und dem zweiten Leiterbahnbereich verschaltet. Es sei angemerkt, dass die Solarzelle auch eine Diodencharakteristik aufweist und die Schutzdiode antiparallel zu der Solarzelle geschaltet ist. Die aus der Oberseite des Trägers hervorstehenden Flächen der Schutzdiode sind vorzugsweise von der Polymerkleberschicht bedeckt.

In einer bevorzugten Ausführungsform ist das sekundäre optische Element in Form eines halben Ellipsoids ausgebildet und weist vorzugsweise einen umlaufenden absatzförmigen Kragen auf. In einer anderen Ausführungsform ist das sekundäre optische Element pyramidenstumpfförmig oder trichterförmig ausgebildet. Des Weiteren ist dassekundäre optische Element erfindungsgemäß aus einem anorganischen Material, vorzugsweise aus einer Quarzglasverbindung auszubilden. Ein Vorteil des anorganischen Material bzw. der Quarzglasverbindung ist die sehr gute UV-Transparenz und die außerordentliche hohe Temperaturstabilität sowie eine große mechanische und chemische Widerstandsfähigkeit im Vergleich zu einer organischen bzw. KunststoffVerbindung.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine Querschnittsansicht auf eine erfindungsgemäße Ausführungsform einer Solarzelleneinheit in einer ungefügten Ausführung,
- Figur 2: eine Draufsicht auf einen Träger der Figur 1 mit einer Schutz-Diode,
- Figur 3: eine Querschnittsansicht auf die Ausführungsform entlang der Linie I-I dargestellt in der Figur 2 In einer gefügten Ausführungsform,
- Figur 4: eine Querschnittsansicht entlang der Linie II-II dargestellt In der Figur 2 in der gefügten Ausführungsform,
- Figur 5: eine perspektivische Ansicht auf die gefügte Ausführungsform dargestellt in der Figur 3 und der Figur 4,
- Figur 6: eine perspektivische Ansicht auf die Unterseite des sekundären optischen Elements optisches Element mit einer ellipsodalen Form und einen absatzförmigen Kragen,
- Figur 7: eine perspektivische Ansicht auf die Oberseite des Trägers dargestellt in der Figur 2.

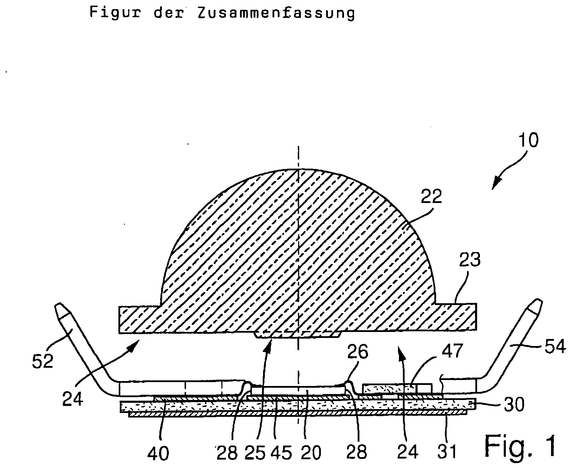

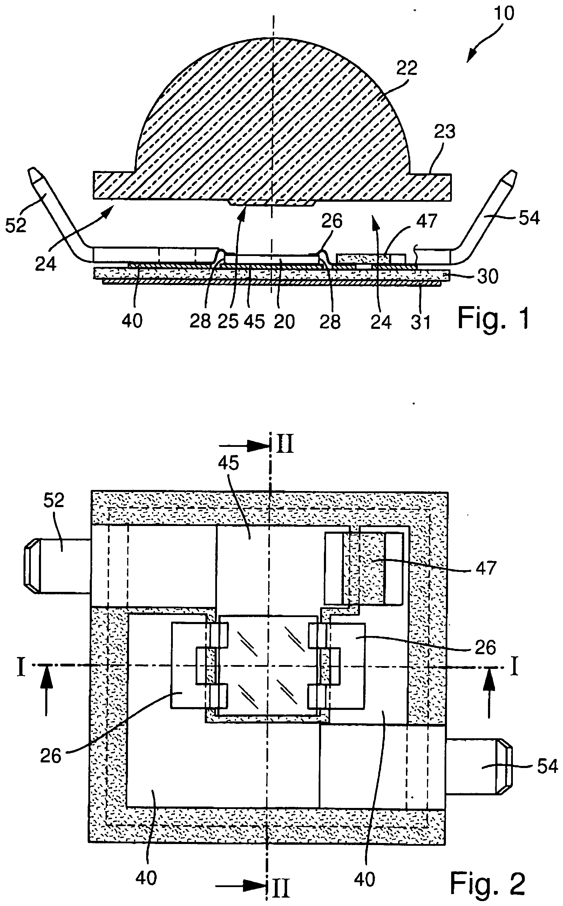

Die Abbildung der Figur 1 zeigt eine Solarzelleneinheit 10 mit einem als Solarzelle ausgebildeten Halbleiterkörper 20, einem sekundären optischen Element 22 In Form eines halben Ellipsoids mit einem umlaufenden kragenförmigen Wulst 23. Das sekundäre optische Element 22 weist eine Unterseite 24 auf und ist an der Unterseite 24 mit Ausnahme eines zentralen Bereichs plan ausgeformt. In dem zentralen Bereich ist eine gegenüber der umgebenden Fläche erhöhte erste Ausformung 25 ausgebildet. Die erhöhte erste Ausformung 25 weist eine plane Oberfläche auf. Das optische Element 22 führt das in das sekundäre optische Element 22 einfallende Licht auf die Vorderseite des Halbleiterkörpers 20, wobei die Oberfläche der ersten Ausformung 25 oberhalb einer Vorderseite des Halbleiterkörpers 20 angeordnet und mit dem Halbleiterkörper 20 kraftschlüssig verbunden ist. Der Träger 30 weist an der Unterseite eine bis auf einen schmalen Randbereich ganzflächige Metallschicht 31 auf, wobei der Träger 30 eine vergleichbare oder gleiche laterale Ausdehnung als die Unterseite 24 das sekundäre optische Element 22 aufweist. Ferner weist der Halbleiterkörper 20 eine Vorderseite mit einem ersten elektrischen Anschlusskontakt und eine Rückseite mit einem zweiten elektrischen Anschlusskontakt und eine zwischen der Vorderseite und der Rückseite ausgebildete Seitenfläche 28 auf. Der Halbleiterkörper 20 ist mit der Rückseite auf einer Oberseite eines Trägers 30 angeordnet.

An der Oberseite des Trägers 30 ist ein erster als Teil des Trägers ausgebildeter Leiterbahnbereich 40 ausgebildet. Der erste Leiterbahnbereich 40 ist mit dem ersten elektrischen Anschlusskontakt mittels mehreren geschweißten Verbindern 26 elektrisch verschaltet. Des Weiteren weist der Träger 30 auf der Oberseite einen zweiten als Teil des Trägers 30 ausgebildeten Leiterbahnbereich 45 auf. Der zweite Leiterbahnbereich 45 und der zweite elektrische Anschlusskontakt sind miteinander elektrisch verschaltet, indem die Rückseite des Halbleiterkörpers 20 auf dem zweiten Leiterbahnbereich 45 aufgelötet ist. Ferner ist auf der Oberseite des Trägers 30 eine Schutzdiode angeordnet. Die Schutzdiode ist als Bypass-Diode 47 ausgebildet. Es versteht sich, dass mit einer anderen Dimensionierung der Schutzdiode auch mehrere Schutzdioden notwendig sind. Auf der Oberseite des Trägers 30 ist ein erster mit dem ersten Leiterbahnbereich 40 elektrisch verschalteter Kontaktstreifen 52 ausgebildet ist, wobei der erste Kontaktstreifen 52 seitlich über die Oberseite hinausragt und ein zweiter mit dem zweiten Leiterbahnbereich 45 elektrisch verschalteter Kontaktstreifen 54 ausgebildet ist und wobei der zweite Kontaktstreifen 54 ebenfalls seitlich über die Oberseite des Trägers 30 hinausragt. Mittels der beiden Kontaktstreifen 52 und 54 lässt sich die Solarzelleneinheit 10 einfach und zuverlässig elektrisch anschließen.

Die Abbildung der Figur 2 eine Draufsicht auf einen Träger dargestellt in der Figur 1 mit einer Schutzdiode. Nachfolgend werden nur die Unterschiede zu der Darstellung in der Figur 1 erläutert. Es zeigt sich, dass die Oberseite des Trägers 30, bis einen schmalen Randbereich, von dem ersten Leiterbahnbereich 40 und von dem zweiten Leiterbahnbereich 45 bedeckt ist, wobei die Schutzdiode 47 mit dem ersten Leiterbahnbereich 40 und mit dem zweiten Leiterbahnbereich 45 elektrisch verschaltet ist. Ferner ist die Vorderseite des Halbleiterkörpers 20 mittels der beiden Schweißverbinder 26 beidseitig niederohmig mit dem ersten Leiterbahnbereich 40 verschaltet. In einer nicht dargestellten Ausführungsform sind die Schweißverbinder 26 als sogenannte "in plane" Verbinder ausgeführt. Der erste Leiterbahnbereich 40 ist von dem zweiten Leiterbahnbereich 45 beabstandet und nur über den Halbleiterkörper 20 und die Schutzdiode 47 elektrisch verbunden.

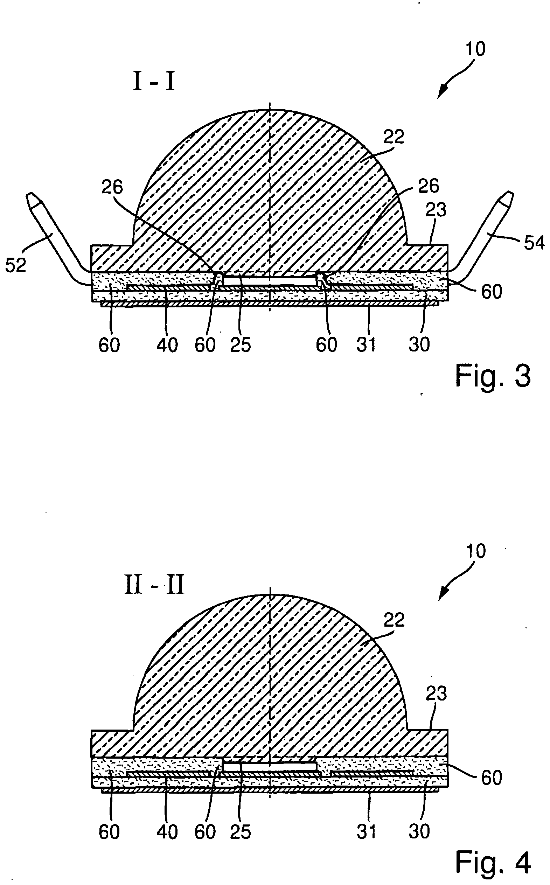

Die Abbildung der Figur 3 bzw. die Abbildung der Figur 4 zeigen eine Querschnittsansicht auf die erfindungsgemäße Ausführungsform entlang der Linie I-I bzw. entlang der Linie II-II jeweils der in der Figur 2 dargestellten gefügten Ausführungsform. Nachfolgend werden nur die Unterschiede zu den Darstellungen In der Figur 1 und der Figur 2 erläutert. Zwischen der Oberseite des Trägers 30 ist als eine Polymerkleberschicht eine Silikonschicht 60 ausgebildet. Die Silikonschicht 60 füllt In Form einer Vergussmasse den Raum zwischen der Unterseite 24 des sekundären optischen Elements 22 und dem Träger 30 formschlüssig vollständig aus und stellt eine kraftschlüssige Verbindung zwischen dem sekundären optischen Element 22 und dem Träger 30 bzw. der Schutzdiode 47 und dem Halbleiterkörper 20 her. Die Silikonschicht 60 überdeckt sowohl die Seitenflächen des Halbleiterkörpers 20 als auch die aus der Oberseite des Trägers 30 herausstehenden Flächen der Schutzdiode. Die Silikonschicht 60 ist kissenförmig ausgebildet und endet bündig an dem Rand des Trägers 30 bzw. mit dem Rand an der Unterseite 24 des sekundären optischen Elements 22.

In einer nicht dargestellten alternativen Ausführungsform ist an der gesamten Unterseite 24 eine stoffschlüssig mit der Unterseite 24 verbundene erste Haftvermittlerschicht ausgebildet. Ferner ist in einer anderen nicht dargestellten alternativen Ausführungsform auf der Vorderseite des Halbleiterkörpers 20 eine zweite Haftvermittlerschicht ausgebildet, wobei die zweite Haftvermittlerschicht mit der Vorderseite des Halbleiterkörpers stoffschlüssig verbunden ist. In einer ebenfalls nicht darstellten Weiterbildung überdeckt die zweite Haftvermittlerschicht wenigstens einen Teil der Oberseite des Trägers 30. Es versteht sich, dass die erste Haftvermittlerschicht und / oder die zweite Haftvermittlerschicht eine im Vergleich zu der Polymerkleberschicht unterschiedliche chemische Zusammensetzung aufweisen.

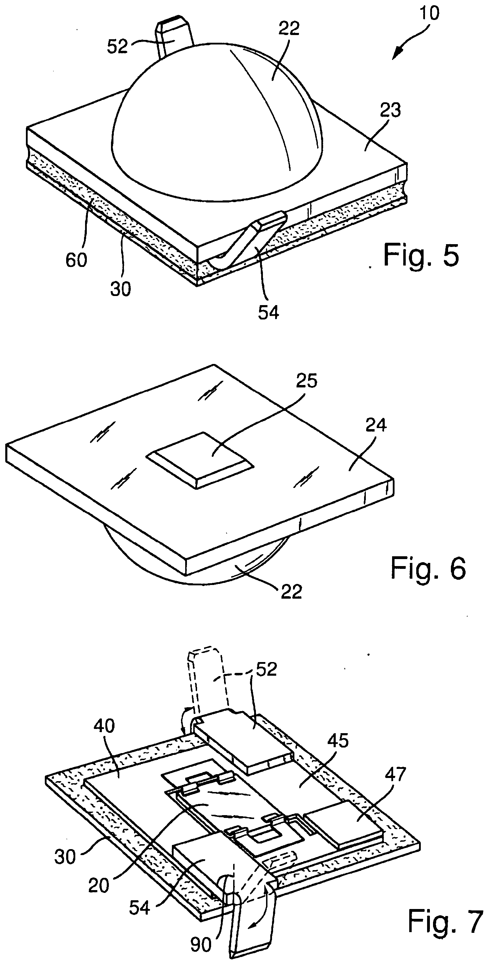

Die Abbildung der Figur 5 zeigt eine perspektivische Ansicht auf die gefügte Ausführungsform dargestellt in der Figur 3 und der Figur 4. Es zeigt sich, dass mittels der erfindungsgemäßen Ausführungsform eine besonders kompakte Solarzelleneinheit 10 herstellen lässt. Zwar sind die beiden Kontaktstreifen 52 und 54 an einander gegenüberliegenden Seiten des Trägers 30 ausgebildet, jedoch sind auch andere Anordnungen mittels anderer Leiterbahnführungen auf einfache Weise herstellbar.

Die Abbildung der Figur 6 zeigt eine perspektivische Ansicht auf die Unterseite 24 des sekundären optischen Elements 22. Es zeigt sich, dass die Ausformung 25 aus der Unterseite 24 herausragt und die Unterseite eine weitestgehend plane Oberfläche aufweist. Die Ausformung 25 zeigt eine plane quadratisch ausgeformte Oberfläche. Es versteht sich, dass die Größe und Form der Ausformung von der Größe der Vorderseite des Halbleiterkörpers 20 bestimmt wird.

Die Abbildung der Figur 7 zeigt eine perspektivische Ansicht auf die Oberseite des Trägers 30 dargestellt In der Figur 2. Es zeigt sich, dass die beiden Kontaktstreifen 52 und 54 sowohl senkrecht, also im Winkel von 90° über die Oberseite des Trägers 30 hinausragen, als auch jeden anderen Winkel zwischen 90 ° und -90 ° annehmen können. Anders ausgedrückt, die beiden Kontaktstreifen 52 und 54 lassen sich beispielsweise auch seitlich entlang der Trägerebene, d. h. im Winkel von 0° anordnen.

## Patentansprüche

1. Solarzelleneinheit (10) mit,
- einem als Solarzelle ausgebildeten Halbleiterkörper (20), aufweisend eine Vorderseite und eine Rückseite und mit zwischen der Vorderseite und der Rückseite des Halbleiterkörpers (20) ausgebildete Seitenflächen (28) und wobei auf der Vorderseite ein erster elektrischer Anschlusskontakt und auf Rückseite ein zweiter elektrischer Anschlusskontakt ausgebildet sind,
- einem Träger (30) mit einer Oberseite und einer Unterseite und mit einem ersten und einem zweiten Leiterbahnbereich (40, 45), die auf der Oberseite des Trägers (30) als Teil des Trägers (30) ausgebildet sind, wobei die beiden Leiterbahnbereiche (40, 45) von einander beabstandet sind und der erste Leiterbahnbereich (40) an den ersten Anschlusskontakt elektrisch angeschlossen ist und der zweite Anschlusskontakt mit dem zweiten Leiterbahnbereichs (45) elektrisch verschaltet ist, indem die Rückseite (34) des Halbleiterkörper mit einem Teil des zweiten Leiterbahnbereichs (45) kraftschlüssig verbunden ist, und
- einem sekundären optischen Element (22), wobei das sekundäre optische Element (22) einstückig aus einem anorganischen Material ausgebildet ist und Licht auf die Vorderseite des Halbleiterkörpers (20) führt, und das sekundäre optische Element (22) eine Unterseite (24) aufweist, wobei
- das sekundäre optische Element (22) an der Unterseite (24) mit Ausnahme eines zentralen Bereichs plan ausgeformt ist und an der Unterseite (24) in dem zentralen Bereich eine gegenüber der umgebenden Fläche erhöhte Ausformung (25) mit einer planen Oberfläche aufweist und
- die Oberfläche der ersten Ausformung (25) auf der Vorderseite des Halbleiterkörpers (20) angeordnet und mit dem Halbleiterkörper (20) kraftschlüssig verbunden ist und
- sowohl zwischen der ersten Ausformung (25) der Unterseite (24) und der Vorderseite des Halbleiterkörpers (20) als auch zwischen der die Ausformung umgebenden Fläche der Unterseite (24) und der Oberseite des Trägers (30) eine Polymerkleberschicht ausgebildet ist, um das sekundäre optische Element (22) mit dem Halbleiterkörper (20) und mit dem Träger (30) kraftschlüssig zu verbinden, wobei
- die Polymerkleberschicht kissenartig und formschlüssig den Raum zwischen der Unterseite (24) des sekundären optischen Elements (22) und der Oberseite des Trägers (30) ausfüllt und seitlich bündig mit dem äußeren Rand an der Oberseite des Trägers (30) abschließt.

2. Solarzelleneinheit (10) nach Anspruch 1, **dadurch gekennzeichnet, dass** die Polymerkleberschicht eine Kunststoffverbindung umfasst.

3. Solarzelleneinheit (10) nach Anspruch 1 oder 2, **dadurch gekennzeichnet, dass** die Polymerkleberschicht eine Silikonverbindung (60) umfasst.

4. Solarzelleneinheit (10) nach einem der Ansprüche 1 bis 3, **dadurch gekennzeichnet, dass** die Polymerkleberschicht zwischen der gesamten Unterseite (24) des sekundären optischen Elements (22) und der Oberseite des Trägers (30) ausgebildet ist.

5. Solarzelleneinheit (10) nach einem der Ansprüche 1 bis 4, **dadurch gekennzeichnet, dass** ein erster mit dem ersten Leiterbahnbereich (40) elektrisch verschalteter Kontaktstreifen (52) ausgebildet ist und der erste Kontaktstreifen (52) seitlich über die Oberseite hinausragt und ein zweiter mit dem zweiten Leiterbahnbereich (45) elektrisch verschalteter Kontaktstreifen (54) ausgebildet ist und der zweite Kontaktstreifen (54) seitlich über die Oberseite hinausragt.

6. Solarzelleneinheit (10) nach einem der Ansprüche 1 bis 5, **dadurch gekennzeichnet, dass** auf der Oberseite des Trägers (30) eine Schutzdiode (47) angeordnet und die Schutzdiode elektrisch mit dem Halbleiterkörper (20) und kraftschlüssig mit der Oberseite des Trägers (30) verbunden ist.

7. Solarzelleneinheit (10) nach einem der Ansprüche 1 bis 6, **dadurch gekennzeichnet, dass** das sekundäre optische Element (22) eine Quarzglasverbindung umfasst.

8. Solarzelleneinheit (10) nach einem der Ansprüche 1 bis 7, **dadurch gekennzeichnet, dass** das sekundäre optische Element (22) linsenförmig oder trichterförmig ausgebildet ist.

9. Solarzelleneinheit (10) nach einem der Ansprüche 1 bis 8, **dadurch gekennzeichnet, dass** die Fläche an der Oberseite des Trägers (30) gleich groß wie die Fläche an der Unterseite (24) des sekundären optischen Elements (22) ist.

10. Solarzelleneinheit (10) nach einem der Ansprüche 1 bis 9, **dadurch gekennzeichnet, dass** der Träger (30) plattenförmig ausgebildet ist und eine Keramikverbindung umfasst.

11. Solarzelleneinheit (10) nach einem der Ansprüche 1 bis 10, **dadurch gekennzeichnet, dass** an der Unterseite des Trägers (30) eine Metallschicht (31) ausgebildet ist.

12. Solarzelleneinheit (10) nach einem der Ansprüche 1 bis 11, **dadurch gekennzeichnet, dass** zwischen der Oberfläche der Ausformung (25) und der Polymerkleberschicht eine erste Haftvermittlerschicht ausgebildet ist.

13. Solarzelleneinheit (10) nach einem der Ansprüche 1 bis 12, **dadurch gekennzeichnet, dass** zwischen der Vorderseite des Halbleiterkörpers (20) und der Polymerkleberschicht eine zweite Haftvermittlerschicht ausgebildet ist.

## Claims

1. Solar cell unit (10) comprising
- a semiconductor body (20) which is constructed as a solar cell and which has a front side and a rear side and with side surfaces (28) formed between the front side and the rear side of the semiconductor body (20), wherein a first electrical connecting contact is formed on the front side and a second electrical connecting contact is formed on the rear side,
- a support (30) with an upper side and a lower side and with a first conductor track region (40) and second conductor track region (45), which are formed on the upper side of the support (30) as part of this support (30), wherein the two conductor track regions (40, 45) are spaced from one another and the first conductor track region (40) is electrically connected with the first connecting contact and the second connecting contact is electrically connected with the second conductor track region (45) in that the rear side (34) of the semiconductor body is connected with a part of the second conductor track region (45) by frictional couple, and
- a secondary optical element (22), wherein the secondary element (22) is formed integrally from an inorganic material and conducts light onto the front side of the semiconductor body (20), the secondary optical element (22) having a lower side (24), wherein
- the secondary optical element (22) is formed to be flat at the lower side (24) with the exception of a central region and has at the lower side (24) in the central region a shaped portion (25), which is elevated relative to the surrounding area, with a planar surface and
- the surface of the first shaped portion (25) is arranged on the front side of the semiconductor body (20) and is connected with the semiconductor body (20) by force-locking coupling and
- a polymer adhesive layer is formed not only between the first shaped portion (25) at the lower side (24) and the front side of the semiconductor body (20), but also between the surface, which surrounds the shaped portion, of the lower side (24) and the upper side of the support (30) so as to connect the secondary optical element (22) with the semiconductor body (20) and with the support (30) by frictional couple, wherein
- the polymer adhesive layer fills out the space between the lower side (24) of the secondary optical element (22) and the upper side of the support (30) in pillow-like and interlocking manner and laterally terminates to be flush with the outer edge at the upper side of the support (30).

2. Solar cell unit (10) according to claim 1, **characterised in that** the polymer adhesive layer comprises a plastics material compound.

3. Solar cell unit (10) according to claim 1 or 2, **characterised in that** the polymer adhesive layer comprises a silicon compound (60).

4. Solar cell unit (10) according to any one of claims 1 to 3, **characterised in that** the polymer adhesive layer is formed between the entire lower side (24) of the secondary optical element (22) and the upper side of the support (30).

5. Solar cell unit (10) according to any one of claims 1 to 4, **characterised in that** a first contact strip (52) electrically connected with the first conductor track region (40) is formed and the first contact strip (52) projects laterally beyond the upper side and a second contact strip (54) electrically connected with the second conductor track region (45) is formed and the second contact strip (54) projects laterally beyond the upper side.

6. Solar cell unit (10) according to any one of claims 1 to 5, **characterised in that** a protective diode is arranged on the upper side of the support (30) and the protective diode is electrically connected with the semiconductor body (20) and frictionally connected with the upper side of the support (30).

7. Solar cell unit (10) according to any one of claims 1 to 6, **characterised in that** the secondary optical element (22) comprises a quartz glass compound.

8. Solar cell unit (10) according to any one of claims 1 to 7, **characterised in that** the secondary optical element (22) is formed to be lens-shaped or funnel-shaped.

9. Solar cell unit (10) according to any one of claims 1 to 8, **characterised in that** the surface at the upper side of the support (30) is the same size as the surface at the lower side (24) of the secondary optical element (22).

10. Solar cell unit (10) according to any one of claims 1 to 9, **characterised in that** the support (30) is formed to be plate-shaped and comprises a ceramic compound.

11. Solar cell unit (10) according to any one of claims 1 to 10, **characterised in that** a metal layer (31) is formed at the lower side of the support (30).

12. Solar cell unit (10) according to any one of claims 1 to 11, **characterised in that** a first adhesion-promoting layer is formed between the upper surface of the shaped portion (25) and the polymer adhesive layer.

13. Solar cell unit (10) according to any one of claims 1 to 12, **characterised in that** a second adhesion-promoting layer is formed between the front side of the semiconductor body (20) and the polymer adhesive layer.

## Revendications

1. Unité de cellules solaires (10), comprenant:
un corps semi-conducteur (20), réalisé sous la forme d'une cellule solaire, qui présente un côté avant et un côté arrière et qui possède des faces latérales (28) formées entre le côté avant et le côté arrière du corps semi-conducteur (20), et dans laquelle un premier contact de raccordement électrique est formé sur le côté avant et un second contact de raccordement électrique est formé sur le côté arrière,
un support (30) qui présente un côté supérieur et un côté inférieur et qui possède une première et une seconde zones de piste conductrice (40, 45) qui sont formées sur le côté supérieur du support (30) sous la forme d'une partie du support (30), dans laquelle les deux zones de piste conductrice (40, 45) sont espacées l'une de l'autre et la première zone de piste conductrice (40) est électriquement raccordée au premier contact de raccordement et le second contact de raccordement est électriquement relié à la seconde zone de piste conductrice (45), par le fait que le côté arrière (34) du corps semi-conducteur est assemblé par friction à une partie de la seconde zone de piste conductrice (45), et
un élément optique secondaire (22), dans laquelle l'élément optique secondaire (22) est réalisé d'un seul tenant en un matériau inorganique et conduit la lumière sur le côté avant du corps semi-conducteur (20), et l'élément optique secondaire (22) présente un côté inférieur (24), dans laquelle
l'élément optique secondaire (22) est de forme plane sur le côté inférieur (24), à l'exception d'une zone centrale, et comporte sur le côté inférieur (24), dans la zone centrale, une protubérance (25) qui présente une surface plane surélevée par rapport à la face environnante, et
la surface de la première protubérance (25) est disposée sur le côté avant du corps semi-conducteur (20) et est assemblée par friction au corps semi-conducteur (20), et
une couche de colle polymère est formée aussi bien entre la première protubérance (25) du côté inférieur (24) et le côté avant du corps semi-conducteur (20) qu'entre la face du côté inférieur (24) qui entoure la protubérance et le côté supérieur du support (30), afin d'assembler par friction l'élément optique secondaire (22) au corps semi-conducteur (20) et au support (30), dans laquelle
la couche de colle polymère remplit à la manière d'un coussin et en épousant sa forme l'espace entre le côté inférieur (24) de l'élément optique secondaire (22) et le côté supérieur du support (30) et le ferme latéralement à fleur du bord extérieur sur le côté supérieur du support (30).

2. Unité de cellules solaires (10) selon la revendication 1, **caractérisée en ce que** la couche de colle polymère comprend un composé de matière plastique.

3. Unité de cellules solaires (10) selon la revendication 1 ou 2, **caractérisée en ce que** la couche de colle polymère comprend un composé de silicium (60).

4. Unité de cellules solaires (10) selon l'une quelconque des revendications 1 à 3, **caractérisée en ce que** la couche de colle polymère est formée entre tout le côté inférieur (24) de l'élément optique secondaire (22) et le côté supérieur du support (30).

5. Unité de cellules solaires (10) selon l'une quelconque des revendications 1 à 4, **caractérisée en ce qu'**elle comporte une première lame de contact (52) électriquement reliée à la première zone de piste conductrice (40), et la première lame de contact (52) s'étend latéralement au-delà du côté supérieur, et **en ce qu'**elle comporte une seconde lame de contact (54) électriquement reliée à la seconde zone de piste conductrice (45), et la seconde lame de contact (54) s'étend latéralement au-delà du côté supérieur.

6. Unité de cellules solaires (10) selon l'une quelconque des revendications 1 à 5, **caractérisée en ce qu'**une diode de protection (47) est disposée sur le côté supérieur du support (30), et la diode de protection est électriquement raccordée au corps semi-conducteur (20) et est assemblée par friction au côté supérieur du support (30).

7. Unité de cellules solaires (10) selon l'une quelconque des revendications 1 à 6, **caractérisée en ce que** l'élément optique secondaire (22) comprend un composé de verre de quartz.

8. Unité de cellules solaires (10) selon l'une quelconque des revendications 1 à 7, **caractérisée en ce que** l'élément optique secondaire (22) est réalisé en forme de lentille ou en forme d'entonnoir.

9. Unité de cellules solaires (10) selon l'une quelconque des revendications 1 à 8, **caractérisée en ce que** la face sur le côté supérieur du support (30) a la même grandeur que la face sur le côté inférieur (24) de l'élément optique secondaire (22).

10. Unité de cellules solaires (10) selon l'une quelconque des revendications 1 à 9, **caractérisée en ce que** le support (30) est réalisé en forme de plaque et comprend un composé de céramique.

11. Unité de cellules solaires (10) selon l'une quelconque des revendications 1 à 10, **caractérisée en ce qu'**une couche métallique (31) est formée sur le côté inférieur du support (30).

12. Unité de cellules solaires (10) selon l'une quelconque des revendications 1 à 11, **caractérisée en ce qu'**une première couche d'agent adhésif est formée entre la surface de la protubérance (25) et la couche de colle polymère.

13. Unité de cellules solaires (10) selon l'une quelconque des revendications 1 à 12, **caractérisée en ce qu'**une seconde couche d'agent adhésif est formée entre le côté avant du corps semi-conducteur (20) et la couche de colle polymère.
